(19) Europäisches Patentamt
European Patent Office
Office européen des brevets

(11) **EP 2 977 202 A1**

(12) **DEMANDE DE BREVET EUROPEEN**

(43) Date de publication:
**27.01.2016 Bulletin 2016/04**

(51) Int Cl.:
**B32B 17/10** (2006.01)     **H05B 3/20** (2006.01)
**C03C 27/12** (2006.01)

(21) Numéro de dépôt: **14178590.7**

(22) Date de dépôt: **25.07.2014**

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**

(71) Demandeur: **AGC Glass Europe
1348 Louvain-la-Neuve (BE)**

(72) Inventeurs:
• **Dumont, Jacques
5537 Bioul (BE)**

• **Masschelein, Peter
3040 Huldenberg (BE)**
• **Depauw, Jean-Michel
1083 Bruxelles (BE)**

(74) Mandataire: **Le Vaguerèse, Sylvain Jacques
AGC Glass Europe
Technovation Centre
IP Department
Rue Louis Blériot, 12
6041 Gosselies (BE)**

(54) **Vitrage chauffant**

(57)     L'invention concerne un vitrage automobile feuilleté composé de deux feuilles de verre réunies au moyen d'une feuille intercalaire thermoplastique, vitrage comportant un système couches conductrices appliqué sur une des feuilles, et comportant sur le bord de la même feuille une bande de masquage sensiblement opaque, en contact avec la feuille de verre, le système de couches conductrices recouvrant au moins en partie la bande de masquage, vitrage qui comporte encore des busbars d'alimentation électrique en contact avec le système de couches dans la partie recouvrant la bande de masquage, caractérisé en ce que la bande de masquage est constituée d'un ensemble de couches absorbant le rayonnement visible, ces couches étant formées par pulvérisation cathodique.

Fig.1

Printed by Jouve, 75001 PARIS (FR)

**Description**

L'invention concerne les vitrages automobiles comportant un système de couches conductrices destiné au chauffage du vitrage. De manière plus précise l'invention est relative à l'amélioration des performances de ces vitrages par les conditions dans lesquelles le système de couches est alimenté.

En pratique les vitrages chauffants à couches sont raccordés à l'alimentation électrique au moyen de conducteurs appliqués sur les bords du vitrage et en contact avec les couches. A l'expérience le contact électrique entre les conducteurs en question, désignés sous le nom de «busbars», et le système de couches n'est pas toujours assuré dans les meilleures conditions. Les irrégularités dans ce contact ont pour conséquence une distribution de la puissance qui n'est pas optimisée d'une part, et d'autre part la formation de zones privilégiées pour le passage du courant, crée ce qui est désigné sous le nom de «points chauds». Même si ces derniers restent dans des températures supportables par les matériaux entrant dans la constitution du vitrage, la distribution non homogène de la puissance électrique limite les performances atteintes.

Dans les conditions les plus usuelles la tension applicable étant limitée le plus généralement à 12-14v pour les véhicules particuliers- et la résistance des couches ne pouvant pas être abaissée pour des raisons liées à la transmission lumineuse de ces vitrages et à leur coloration en réflexion, la puissance effective disponible est limitée. Il est nécessaire d'approcher des conditions qui visent à consacrer la quasi-totalité de cette puissance au chauffage du vitrage. Toute perte de puissance notamment à l'interface des busbars et des couches conductrices réduit les performances de chauffage. Cette perte de puissance est particulièrement gênante pour les vitrages présentant les plus grandes dimensions. Dans les véhicules les vitrages les plus exigeants sont les pare-brise. Dans la suite, l'invention est décrite en référence aux pare-brise étant entendu que les propositions s'appliquent aussi aux vitrages de dimensions plus modestes.

Les vitrages chauffants, en dehors des couches et des busbars, comportent le plus généralement des moyens destinés à masquer des éléments inesthétiques situés derrière ces vitrages. Pour les vitrages collés, le cordon de colle irrégulier serait visible de l'extérieur sauf à opacifier la zone de collage correspondante située nécessairement sur le bord du vitrage. Les busbars font aussi partie des éléments qui doivent être dissimulés à la vue depuis l'extérieur du véhicule.

Le masquage des bords du vitrage est traditionnellement réalisé par application d'une composition d'émail qui opacifie en pratique complètement cette zone du vitrage. La transmission lumineuse dans la zone revêtue de cet émail est par exemple inférieure à 1% et, habituellement, peut être inférieure à 0,1% de la lumière incidente.

De manière générale les grandeurs optiques, transmission lumineuse (TL), réflexion coté verre ($R_g$) et côté couches ($R_c$), absorption... sont déterminées pour une feuille de verre clair de 4mm d'épaisseur pour un illuminant normalisé D65 sous un angle solide de 2°. Les grandeurs colorimétriques L*, a*, b* sont exprimées dans le système CIELab, également pour un illuminant D65, 10°, la mesure étant faite sous un angle de 8° par rapport à la normale à la feuille de verre.

L'application de la composition émaillée est traditionnellement réalisée par une technique de sérigraphie. L'application faite, la composition est cuite pour constituer la couche d'émail. Cette «cuisson» est soit en une seule soit en deux étapes. Dans le second, celui suivi le plus souvent dans la production des vitrages feuilletés, une première cuisson conduit à l'élimination des solvants qui stabilise momentanément le motif imprimé, une seconde cuisson conduit à la fusion de la fritte présente dans la composition. Ces deux étapes correspondent le plus souvent à deux moments de la préparation des vitrages. Le premier est effectué sur la feuille sur laquelle la composition est appliquée, le second correspond avantageusement au traitement thermique de bombage.

Dans les vitrages feuilletés, notamment les pare-brise, l'émail de masquage est appliqué nécessairement au moins sur la feuille tournée vers l'extérieur du véhicule. Le système de couches chauffantes est aussi avantageusement appliqué sur cette feuille pour optimiser le chauffage nécessaire pour le dégivrage qui constitue l'opération nécessitant le maximum de puissance. Les busbars sont disposés sur le système de couches conductrices en regard des zones émaillées. L'ensemble de ces éléments se situe sur la face de la feuille en contact avec l'intercalaire thermoplastique, la face 2 dans la désignation traditionnelle qui numérote les faces des feuilles depuis l'extérieur.

Les inventeurs ont analysé le comportement du système de couches conductrices disposé sur une bande traditionnelle d'émail de masquage. Ils ont montré que la puissance délivrée aux busbars n'était au mieux qu'en partie transmise aux couches conductrices situées sur la zone de vision du pare- brise. Il en résulte une perte de puissance préjudiciable aux performances de chauffage du vitrage. L'étude de l'origine de cette perte de puissance a permis d'identifier certains facteurs dont la prise en compte peut conduire à une amélioration de ces performances.

L'invention résulte de cette identification et de la façon de remédier aux causes de cette perte de puissance. L'invention est l'objet de la revendication 1 qui se rapporte à l'influence de l'application du système de couches conductrices sur les bandes de masquage et propose une alternative aux bandes traditionnelles d'émail.

Une cause identifiée de la perte de puissance électrique utile pour le chauffage du vitrage est liée à la difficulté d'assurer une parfaite continuité des couches conductrices au niveau du bord de la bande de masquage. Cette difficulté provient principalement de l'épaisseur de la bande émaillée. L'épaisseur des couches conductrices est très inférieure à celle de la bande émaillée. Au bord de la couche émaillée les couches conductrices doivent franchir, sans discontinuité ni réduction significative de leur section, le seuil qui est de plusieurs dizaines, voire plusieurs centaines de fois leur épaisseur. Les bandes émaillées ont une épaisseur de l'ordre de 20 à 150μ, l'épaisseur des systèmes de couches conductrices mêmes les plus complexes est de l'ordre de 0,3-0,4μ.

Le remplacement selon l'invention, telle que revendiquée, des bandes émaillées par une bande opaque constituée par des couches minces permet de minimiser cet effet de seuil et les défauts qui en résultent.

Les couches minces utilisées sur des substrats verriers ont de multiples applications. Les plus usuelles visent le contrôle solaire et notamment celui des transmissions énergétiques par une réflexion sélective des infrarouges. Des couches minces sont aussi couramment utilisées comme électrodes conductrices. D'autres couches servent à minimiser la réflexion des vitrages etc. Les exigences pour ce qui concerne l'utilisation comme bande masquage ne correspondent pas à celles des applications antérieures.

Antérieurement il a été proposé des vitrages revêtus de couches conduisant à une faible transmission lumineuse. La publication WO2012/095380 propose ainsi des toits pour véhicules automobile dont la transmission lumineuse peut atteindre des valeurs aussi faibles que 5%. La composition des couches proposée dans ce document comprend de façon générale une ou plusieurs couches métalliques absorbantes notamment dans le domaine des longueurs d'onde du visible, et des couches diélectriques essentiellement transparentes qui ont pour rôle de protéger les couches métalliques.

La particularité des bandes de masquage selon l'invention, et donc des couches qui les composent, est de présenter une totale, ou pratiquement totale opacité. La transmission lumineuse doit être au plus de 1% et de préférence ne dépasse pas 0,5%, et de façon particulièrement préférée au plus de 0,1%. Cette propriété est à l'opposé de celle requise dans de nombreuses applications dans lesquelles on s'efforce au contraire de maintenir une transmission du domaine visible aussi élevée que possible.

L'avantage des couches minces déposées par pulvérisation cathodique est que ces couches restent relativement minces tout en conduisant à l'opacité requise. Les systèmes de couches selon l'invention présentent une épaisseur totale qui n'est pas supérieure à 4000Å et de préférence pas supérieure à 3000Å.

Les systèmes de couches utilisés selon l'invention pour constituer les bandes de masquage comprennent au moins une couche absorbante/réfléchissante d'un métal ou alliage est du groupe comprenant : W, Cr, Ta, Al, Cu, Nb, Zr, Ti, Mo, V, Hf et, NiCr, NbCr, CoCr, ZrCr, NiCrW et les aciers inoxydables ; ainsi éventuellement que les composés absorbant constitués à partir de ces métaux en particulier les composés au moins partiellement nitrurés.

Parmi les métaux et alliages sont préférés ceux le Cr, Zr, W, Al et leurs alliages.

Schématiquement la structure du système de couches mis en oeuvre répond à la forme :

$$G/\ldots M1/\ldots$$

G étant la feuille de verre M1 la couche absorbante/réfléchissante, les systèmes comprenant d'autres éléments dont il est question dans la suite.

La couche absorbante peut être composée de plusieurs couches «partielles» absorbantes de la liste indiquée ci-dessus du type/

$$G/\ldots M1(M1_a/M1_b/M1_c)\ldots/\ldots$$

Par ailleurs dans les applications les plus usuelles les constructeurs demandent que ces bandes de masquage présentent une réflexion vers l'extérieur aussi faible que possible. Elles doivent se faire les plus discrètes possibles, et ne doivent pas se transformer en «miroirs». La réflexion dans le domaine du visible est ainsi de préférence inférieure à 8% du côté verre ($R_g$). De préférence cette réflexion n'est pas supérieure à 5%.

Les constructeurs préfèrent généralement que ces bandes de masquage restent sans «apparence colorée». La lumière réfléchie par les parties du vitrage revêtues de ces couches de masquage est de couleur aussi neutre que possible. En colorimétrie cette condition s'exprime par exemple par le fait que les coordonnées a* et b* du système CIELab sont proches de 0. Les parties du vitrage ainsi revêtues donnent une apparence sensiblement noire et mate. Mais il est possible, sans sortir de l'invention, de donner aux bandes de masquage une certaine coloration au gré de la demande des constructeurs. Cette coloration apparaitra d'autant plus que la réflexion est plus intense.

Les bandes opaques doivent aussi présenter une grande résistance aux traitements thermiques. Les vitrages considérés sont pratiquement tous soumis à des bombages ou des trempes menés à des températures de l'ordre de 650 à 700°C pendant une dizaine de minutes. Il est nécessaire que les propriétés des bandes de masquage ne soient pas altérées à la fin du traitement et, par exemple, ne présentent pas d'irisations. Le cas échéant pour améliorer la résistance de cette couche absorbante, il est possible de lui adjoindre des couches minces qualifiées de «sacrificielles» ou «barrière», lesquelles n'ont pour rôle que de protéger la couche absorbante. Le schéma de structure est alors du type :

$$G/\ldots B1/M1/B2\ldots$$

Les couches barrière B1 et B2 sont employées simultanément soit individuellement, et peuvent être identiques ou différentes. Ce sont le plus souvent des couches constituées de façon connue pour protéger la couche fonctionnelle contre une altération notamment par oxydation.

Selon l'invention, les couches utilisées pour servir de masquage peuvent avantageusement combiner les mécanismes d'absorption d'une part, et de réflexion/interférence d'autre part.

Si de manière générale l'absorption croît avec l'épaisseur de la couche M1, la réflexion progresse aussi avec cette épaisseur. En conséquence pour répondre aux exigences indiquées précédemment il faut rechercher le meilleur compromis en jouant de nombreux facteurs. Il s'agit du choix de la nature des couches, et de leur épaisseur pour les matériaux absorbants et réfléchissants, mais aussi de celles des couches diélectriques qui, avec les couches absorbantes/réfléchissantes, conditionnent les interférences optiques qui permettent de minimiser les réflexions.

Les couches absorbantes/réfléchissantes pour conduire à une bonne absorption sans accroître de manière excessive leur épaisseur, présentent avantageusement un coefficient d'extinction $\underline{k}$, déterminé pour la moyenne arithmétique des valeurs pour les longueurs d'onde du domaine visible (350-750nm), qui n'est pas inférieur à 2,5, et de préférence pas inférieur à 3.

Pour constituer un obstacle quasi complet à la transmission lumineuse, les couches absorbantes et réfléchissantes présentent des épaisseurs ordinairement supérieures à celles des couches antérieurement proposées. Dans la publication indiquée ci-dessus, les exemples fournis présentent des couches absorbantes dont l'épaisseur ne dépasse pas 250Å. De préférence les bandes de masquage selon l'invention comportent au moins une couche absorbante/réfléchissante, dont, selon la nature de ces couches, l'épaisseur n'est pas inférieure à 300Å et de préférence pas inférieure à 400Å.

L'épaisseur choisie est fonction de la nature de la couche métallique et donc son coefficient d'extinction. Pour les couches les moins absorbantes la tendance est donc d'accroître l'épaisseur. Cette augmentation peut se traduire par une proportion importante de la réflexion. De préférence pour limiter cette tendance les couches absorbantes/réfléchissantes métalliques ont une épaisseur qui n'est pas supérieure à 900Å et de préférence pas supérieure à 800Å.

Une des difficultés résolues selon l'invention est de parvenir à concilier une très forte absorption avec une réflexion limitée vers l'extérieur. Comme indiqué précédemment l'accroissement de l'épaisseur de la couche absorbante conduit nécessairement à un accroissement de la réflexion. Dans ces conditions pour parvenir aux produits satisfaisant aux conditions énoncées, il faut optimiser le choix des matériaux, celui des épaisseurs utilisées, et la mise en oeuvre de dispositions permettant un meilleur contrôle de la réflexion notamment en jouant d'interférences optiques établies par des combinaisons de couches.

Ce dernier point conduit avantageusement à la mise en oeuvre d'une deuxième couche absorbante/réfléchissante, M2, de même nature ou de nature différente de la couche absorbante/réfléchissante principale M1 dont il est question précédemment. Cette deuxième couche dans le système de couches constituant la bande de masquage se situe entre la feuille de verre sur laquelle la bande de masquage est appliquée et la couche absorbante/réfléchissante dont il est question précédemment. La structure de ce système est schématisée ainsi :

$$G/\ldots/M2/\ldots/M1/\ldots$$

Cette seconde couche, M2, dont une fonction est de limiter la réflexion peut présenter des particularités distinctes de celles de la première couche absorbante/réfléchissante, M1. Si les mêmes matériaux métalliques peuvent être utilisés, à savoir : W, Cr, Ta, Al, Cu, Nb, Zr, Ti, Mo, V, Hf et, NiCr, NbCr, CoCr, ZrCr, NiCrW et les aciers inoxydables, et les composés partiellement ou complètement nitrurés dérivés des précédents. Ces derniers offrent la particularité comme les métaux d'une certaine conductivité même si celle-ci est sensiblement moindre.

Cette couche M2 comme la couche M1 peut être composée de plusieurs couches partielles.

Les caractéristiques de cette seconde couche M2 diffèrent sensiblement de celles de la première couche absorbante/réfléchissante M1. Le coefficient d'extinction peut être sensiblement moins élevé, et l'épaisseur également moins importante. De préférence cette seconde couche M2 qui permet de réduire la réflexion présente une épaisseur qui est comprise entre le tiers et le dixième de l'épaisseur de la première couche absorbante/réfléchissante M1.

Les caractéristiques de cette seconde couche dont les propriétés dépendent de facteurs multiples comme indiqué précédemment, peuvent aussi être exprimées par rapport aux valeurs du produit du coefficient d'extinction $\underline{k}$

(moyenne des coefficients sur le domaine des longueurs d'onde du visible), par l'indice de réfraction $\underline{n}$ et par l'épaisseur de la couche $\underline{e}$ exprimée en Angström. Ce produit, k.n.e, est de préférence au moins égal à 300 et de façon particulièrement préférée au moins égal à 400.

Indépendamment de leurs caractéristiques optiques, parmi les métaux et alliages de M1 et éventuellement de M2 (lorsque M2 est un métal ou alliage) sont préférés ceux qui sont peu sensibles aux traitements thermiques susceptibles d'en modifier les propriétés. Dans l'hypothèse de l'utilisation de métaux très sensibles à l'oxydation comme le titane, ils sont de préférence protégés par des couches barrière, comme indiqué précédemment, ou sous forme d'alliage plus résistant.

Parmi les combinaisons les plus résistantes figurent les alliages à base de Ni de Cr, de Zr, de Nb, de W tels que NiCr, ZrCr, NbZr, NiCrW et les aciers inoxydables notamment d'Inconel.

Selon l'invention un alliage particulièrement préféré est à base de tungstène et de nickel. Le tungstène représente au moins 40%. Avantageusement cet alliage comprend en plus du chrome.

Le système de couches composant les bandes de masquage comprennent encore des couches diélectriques contribuant notamment à l'établissement des systèmes interférentiels limitant la réflexion. Comme pour les couches absorbantes, chacune des couches diélectriques peut comprendre plusieurs couches partielles.

Une première couche diélectrique est avantageusement appliquée directement au contact de la feuille de verre.

$$G/D1/\ldots$$

Cette couche peut intervenir de plusieurs façons, d'une part comme protection des couches qui lui sont superposées en constituant une barrière à la diffusion d'ions provenant de la feuille de verre au cours des traitements thermiques. Dans cette fonction des couches comme $SiO_2$ connues pour former un obstacle efficace à la migration peuvent être utilisées. Le faible indice de réfraction de $SiO_2$ fait que cette couche ne participe pas à la limitation de la réflexion. Pour faire en sorte que la couche participe significativement au «dé-réfléchissement» la couche diélectrique D1 doit présenter de façon connue un indice de réfraction supérieur à celui de la feuille de verre sur laquelle elle est appliquée. Son indice est donc avantageusement supérieur à 1,5 et de préférence supérieur à 1,7. Des couches diélectriques préférées sont notamment de $Si_3N_4$, $SiO_xN_y$, AlN, $SnO_2$, Zn SnO, $TiO_2$. Selon le système l'épaisseur de D1 se situe avantageusement entre de 200 à 700Å. De façon préférée une structure du système de couches selon l'invention répond au schéma suivant :

$$G/D1/M2/D2/M1\ldots$$

D2 peut être de même nature ou de nature différente de celle de D1. En plus des matériaux indiqués ci-dessus, les diélectriques traditionnels transparents sont utilisables, $SiO_2$, $TiO_2$, ZnO, $Al_2O_3$ $SnO_2$, ITO, ZnSnO...

La couche D2 est essentiellement destinée au rôle de limitation de la réflexion. Son épaisseur et son indice de réfraction sont déterminées par cette fonction. Elle se situe environ 200-900Å, et de préférence entre 300 et 800 Å.

Les systèmes de couches peuvent encore comprendre une couche diélectrique D3, superposée à la couche M1 dans le but principalement de protéger le système conduisant au système :

$$G/D1/M2/D2/M1/D3$$

La protection de D3 est d'abord de type mécanique les feuilles comportant ces bandes de masquage une fois incluses dans le vitrage feuilleté se trouvant de fait protégées contre les aléas extérieurs. Cette protection mécanique prend en compte les risques lors des manutentions et du stockage précédant la formation du feuilleté. Cette couche diélectrique intervient aussi pour protéger les systèmes de couches au cours des opérations de traitement thermiques. Dans ces rôles la couche diélectrique D3 est avantageusement une couche dure, notamment des couches de nitrures et son épaisseur peut prendre des valeurs très variées. Cette épaisseur est de préférence d'au moins 100Å.

Dans un mode particulier de mise en oeuvre de l'invention le système de couches peut éventuellement ne pas comporter de couche diélectrique D2 entre les deux couches absorbantes/réfléchissantes. Le système correspond alors à la structure suivante :

$$G/D1/M2/M1/D3$$

La raison pour laquelle ce type de structure est susceptible de conduire à l'ensemble des propriétés recherchées, notamment à une réflexion limitée tient probablement à la présence d'un composé M2 qui remplit les conditions à la fois des couches absorbantes/réfléchissantes et celle de diélectrique, attribuée à la couche D2 dans les structures comportant une telle couche.

L'invention est décrite de façon détaillée dans la suite en faisant référence aux figures dans lesquelles

- la figure 1 illustre la disposition sur une des feuilles de verre des éléments intervenant dans un vitrage comportant un système de couches chauffantes ;

- la figure 2 schématise le bord d'un vitrage feuilleté chauffant.

Dans ces figures le rapport des dimensions n'est pas respecté pour la commodité de l'interprétation.

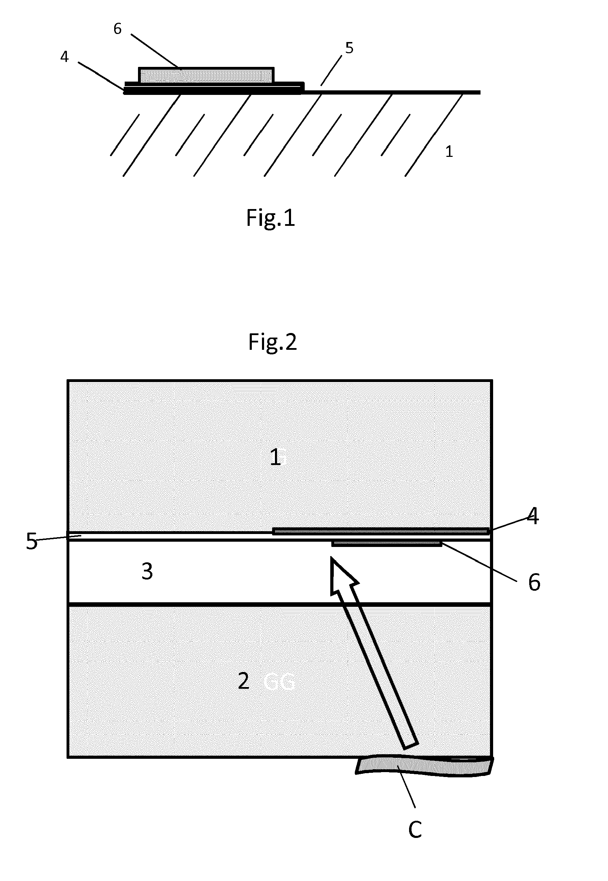

La figure 1 montre la disposition des composants d'un ensemble chauffant à couches sur une feuille de verre d'un vitrage tel qu'un pare-brise.

La feuille de verre 1 comporte une bande de masquage 4 située sur le bord de la feuille. Cette bande est destinée à dissimuler les éléments inesthétiques notamment les busbars 6 alimentant un système de couches conductrices 5 qui s'étend à la fois sur la bande de masquage et directement sur la feuille de verre.

La figure 2 présente un vitrage feuilleté intégrant une feuille de verre est les composants fonctionnels portés par la feuille tels que représentés à la figure 1.

Le vitrage comprend deux feuilles de verre 1, 2 assemblées au moyen d'une feuille intercalaire thermoplastique 3 de type poly-vinyl butyral (PVB) ou éthylène vinyl-acétate (EVA). Les éléments du système chauffant sont tous appliqués sur la face de la feuille de verre tournée vers la feuille intercalaire. La feuille de verre 1 est celle au contact de l'atmosphère extérieure. Cette disposition est préférée dans la mesure où la couche chauffante est au contact immédiat de la feuille qui est directement exposée aux aléas atmosphériques. Compte tenu de la faible conduction thermique des différentes feuilles, verre et intercalaire, la transmission de la chaleur dans cette disposition s'effectue dans les meilleures conditions possibles.

En plus de la bande de masquage 4, la feuille 1 porte le système de couches chauffantes 5 et un collecteur d'alimentation (busbar) 6. La séquence verre/bande de masquage/couche chauffante/busbar est commandée par le rôle de chacun de ces éléments. Le système de couches 5 est nécessairement en contact avec le busbar 6, et celui-ci doit être masqué par la bande 4. Dans cette disposition les couches chauffantes appliquées sur la bande de masquage prolongent la partie de cette couche qui est directement au contact de la feuille de verre 1. Passant de la bande de masquage 4 à la feuille de verre 1, la couche doit franchir le bord de la bande de masquage sans discontinuité ni défaut d'homogénéité pour permettre la transmission la plus élevée possible de la puissance électrique communiquée par l'intermédiaire du busbar 6.

Dans le mode traditionnel, les différences d'épaisseur entre celle des couches conductrices 5 et de la bande de masquage émaillée 4, compromettent la continuité des couches conductrices le long de ce seuil.

Le choix de constituer la bande de masquage 4 par des couches dont l'épaisseur est de l'ordre de grandeur de celle des couches conductrices, réduit de façon significative les défauts constatés avec les bandes émaillées.

Une comparaison est réalisée entre un vitrage dont les bandes de masquage sont produites par sérigraphie d'émail de manière traditionnelle, et un vitrage dont la bande de masquage est obtenue par pulvérisation cathodique selon l'invention.

Dans les deux cas le support est constitué d'une feuille de verre clair de 2,1mm d'épaisseur. Les couches conductrices sont telles que décrites dans la publication WO 2011/147875. Elles comportent trois couches d'argent. L'épaisseur totale des couches varie un peu selon les assemblages proposés, en restant de l'ordre de 4000Å. En règle générale l'épaisseur totale des systèmes de couches conductrices, n'est pas supérieure à $0,6\mu$.

Dans les conditions de l'essai la mesure de la résistance de la couche sur le verre seul s'établit à $0,80\Omega/\square$. Sur la bande de masquage d'émail sérigraphiée traditionnelle, cette résistance est mesurée à $320\Omega/\square$, et celle de la couche conductrice appliquée sur la bande émaillée est de l'ordre de $4\Omega/\square$.

La conduction des couches appliquées sur les bandes émaillées est donc sensiblement altérée en raison notamment de l'importante rugosité des couches émaillées. Cette difficulté est néanmoins beaucoup moins pénalisante que celle correspondant au passage des couches conductrices de la bande émaillée à la feuille de verre. La mesure de résistance au seuil de la bande émaillée, au mieux n'est pas inférieure à $5\Omega/\square$, mais par endroit peut s'élever sans limite lorsque les couches conductrices sont rompues le long de ce seuil.

Dans un premier essai selon l'invention on forme une bande de masquage constituée des couches successives suivantes, les épaisseurs entre parenthèses sont exprimées en Angström.

## Verre/ Si$_3$N$_4$ (563)/NiCrW (72)/ Si$_3$N$_4$ (500)/NiCrW (500)/ Si$_3$N$_4$ (500)

Ce système est appliqué par pulvérisation cathodique assisté par magnétron dans des conditions traditionnelles à partir de cathodes métalliques, en atmosphère d'argon pour les couches métalliques et en atmosphère d'azote pour la constitution des nitrures de silicium.

L'épaisseur totale du système de couches du système de masquage est de 2135 Å, soit 0,2135$\mu$, à comparer avec les épaisseurs habituelles des couches d'émail sérigraphiées qui sont de l'ordre de 20 à 150$\mu$. La bande de masquage obtenue par pulvérisation cathodique est d'une épaisseur comparable à celle du système de couches conductrices. Le «seuil» à la limite de cette bande de masquage est sans commune mesure avec celui correspondant aux émaux traditionnels. La continuité des couches conductrices est mieux assurée. Dans ce cas la mesure de la résistance des couches conductrices est sensiblement la même qu'elle soit mesurée sur la bande de masquage, sur la feuille de verre ou encore sur une partie faisant la transition entre la bande de masquage et la partie dépourvue de cette bande. La mesure dans tous les cas est de 0,78$\Omega$/$\square$, analogue à celle mesurée dans le cas précédent pour ce qui concerne la résistance de la couche conductrice sur le verre.

Le vitrage revêtu de la bande de masquage offre par ailleurs un aspect noir pratiquement neutre une transmission au niveau de cette bande qui est inférieure à 0,5% et une réflexion côté verre de 4,3%. Les indices colorimétriques sont a* 0,1 et b*-0,3.

En l'absence de la couche dé-réfléchissante M2, les résultats optiques sont sensiblement modifiés. Les mesures sont effectuées sur le système de couches absorbant suivant :

## Verre/Si$_3$N$_4$ (500)/NiCrW (500)/Si$_3$N$_4$ (500)

Pour cet ensemble la transmission est un peu plus élevée. Elle s'établit à 2,2%. Mais surtout la réflexion en l'absence de la seconde couche métallique s'accroit de façon importante R$_g$ s'élève à 25,5%, et, simultanément la réflexion est moins neutre, a* 3,1 et b* 0,8.

Différents essais sont entrepris en faisant varier la nature des couches, leurs épaisseurs et la structure de ces ensembles.

1. Dans la structure G/D1/M2/D2/M1/D3 la nature de M1 est variée.

|   | G | D1 | M2 | D2 | M1 | D3 | TL | R$_g$ | a* | b* | k (M1) |
|---|---|----|----|----|----|----|----|-----|----|----|--------|
| 1 | G | Si$_3$N$_4$ 564 | NiCrW 71 | Si$_3$N$_4$ 502 | NiCrW 638 | Si$_3$N$_4$ 500 | 0,2 | 4,3 | 0 | -0,3 | 3 |
| 2 | G | Si$_3$N$_4$ 300 | NiCrW 566 | Si$_3$N$_4$ 476 | NiCrW 83 | Si$_3$N$_4$ 446 | 0,24 | 32 | 0,3 | 10,5 | 3 |
| 3 | G | Si$_3$N$_4$ 588 | NiCrW 87 | Si$_3$N$_4$ 523 | Al 340 | Si$_3$N$_4$ 500 | 0,2 | 4,4 | 0,1 | -0,1 | 6,6 |
| 4 | G | Si$_3$N$_4$ 564 | NiCrW 69 | Si$_3$N$_4$ 564 | Ti 940 | Si$_3$N$_4$ 564 | 0,2 | 4,3 | 0 | -0,3 | 2,6 |
| 5 | G | Si$_3$N$_4$ 553 | NiCrW 59 | Si$_3$N$_4$ 496 | CrN 1315 | Si$_3$N$_4$ 500 | 0,2 | 4,3 | 0 | -0,45 | 1,8 |

Pour les essais 1,3,4 les propriétés recherchées sont satisfaites : très faible transmission, réflexion limitée et neutralité de couleur. Selon la valeur du coefficient d'extinction, l'épaisseur de M1 est plus ou moins importante. Plus k est élevé moins M1 est épais.

L'exemple 2, montre l'importance de la position relative de M1 et M2. Dans cet essai la couche absorbante/réfléchissante la plus épaisse est la plus proche de la feuille de verre. On constate que si l'absorption reste très élevée, la réflexion n'est pas convenablement atténuée du côté de la feuille de verre. Inversement, du côté de la couche la réflexion non indiquée dans le tableau reste faible de l'ordre de 4%.

Partant de la constatation précédente, dans l'hypothèse où la réflexion devrait être faible aussi bien du côté verre que du côté couche, une structure comprenant trois couches absorbantes peut être mise en oeuvre qui correspond à :

## G/D1/M2/D2/M2/D3/M3/D4

A titre d'exemple on prépare l'ensemble :

$$G/Si_3N_4(567)/NiCrW(72)/Si_3N_4(508)/NiCrW(434)/Si_3N_4(448)/NiCrW(84)/Si_3N_4(483)$$

Pour cet ensemble les propriétés de réflexion sont celles obtenues précédemment séparément aux exemples 1 et 2.

L'exemple 5 fait intervenir un matériau (CrN) à caractère conducteur mais de conduction réduite par rapport à un métal ou alliage métallique. Le coefficient d'extinction de ce matériau est nettement moins élevé (1,8) que pour les métaux et alliages. Pour atteindre les performances comparables il est nécessaire d'accroître sensiblement l'épaisseur de la couche correspondante.

2. Dans ces essais la nature de M2 est variée.

| | G | D1 | M2 | D2 | M1 | D3 | TL | $R_g$ | a* | b* | k (M2) |
|---|---|---|---|---|---|---|---|---|---|---|---|
| 6 | G | $Si_3N_4$ 559 | W 90 | $Si_3N_4$ 395 | NiCrW 646 | $Si_3N_4$ 500 | 0,2 | 4,3 | 0 | -0,3 | 3,6 |
| 7 | G | $Si_3N_4$ 497 | Ti 145 | $Si_3N_4$ 609 | NiCrW 648 | $Si_3N_4$ 500 | 0,2 | 4,4 | 0,1 | -0,1 | 2,6 |
| 8 | G | $Si_3N_4$ 479 | Al 34 | $Si_3N_4$ 819 | NiCrW 668 | $Si_3N_4$ 500 | 0,4 | 10,6 | 4,2 | -1,7 | 6,1 |
| 9 | G | $Si_3N_4$ 408 | Cu 95 | $Si_3N_4$ 785 | NiCrW 691 | $Si_3N_4$ 500 | 0,3 | 13,5 | 11,8 | -5 | 3,2 |
| 10 | G | $Si_3N_4$ 501 | Cr 101 | $Si_3N_4$ 684 | NiCrW 655 | $Si_3N_4$ 500 | 0,2 | 4,5 | 0 | -0,2 | 3,6 |
| 11 | G | $Si_3N_4$ 467 | CrN 159 | $Si_3N_4$ 274 | NiCrW 659 | $Si_3N_4$ 500 | 0,2 | 4,3 | 0 | -0,22 | 1,8 |
| 12 | G | $Si_3N_4$ 450 | TiN 291 | $Si_3N_4$ 374 | NiCrW 646 | $Si_3N_4$ 500 | 0,2 | 4,9 | 0,4 | -0,2 | 1,2 |
| 13 | G | $Si_3N_4$ 557 | AZO 1609 | $Si_3N_4$ 1264 | NiCrW 707 | $Si_3N_4$ 500 | 0,2 | 8,85 | 0,8 | 0,28 | 0,2 |
| 14 | G | $Si_3N_4$ 398 | ZrN 250 | | NiCrW 755 | $Si_3N_4$ 500 | 0,26 | 6 | 0 | -0,5 | 0,5 |
| 15 | G | $Si_3N_4$ 510 | TaN 79 | $Si_3N_4$ 99 | NiCrW 774 | $Si_3N_4$ 500 | 0,21 | 5,3 | 0,98 | -0,5 | 1,1 |

Pour les faibles coefficients k l'épaisseur de M2 doit être accrue pour tenter de rétablir les conditions préférées selon l'invention. C'est aussi le résultat exprimé par le produit n.k.e qui figure dans le tableau suivant. Si ce produit est trop faible la réflexion est relativement élevée. C'est les cas par exemple pour l'aluminium (8), ou le cuivre (9). L'accroissement significatif de l'épaisseur peut compenser les coefficients d'extinction très faibles comme pour l'AZO (14).

| | n | k | e | n.k.e |
|---|---|---|---|---|
| 8 | 0,9 | 6,1 | 34 | 182 |
| 7 | 1,9 | 2,6 | 145 | 740 |
| 9 | 0,9 | 3,2 | 95 | 280 |
| 12 | 2,1 | 1,4 | 291 | 848 |
| 14 | 2,7 | 0,2 | 1609 | 809 |
| 10 | 1,8 | 3,6 | 101 | 662 |
| 11 | 3,1 | 1,8 | 159 | 877 |
| 16 | 5,2 | 1,1 | 79 | 458 |
| 6 | 3,5 | 2,7 | 90 | 830 |
| 15 | 3,2 | 0,5 | 250 | 385 |

3. Incidence de D1.

| | G | D1 | M2 | D2 | M1 | D3 | TL | $R_g$ | a* | b* | n (D1) |
|---|---|---|---|---|---|---|---|---|---|---|---|
| 16 | G | $TiO_2$ 436 | NiCrW 104 | $Si_3N_4$ 578 | NiCrW 615 | $Si_3N_4$ 500 | 0,18 | 4,9 | 0,3 | -0,15 | 2,5 |

(suite)

|  | G | D1 | M2 | D2 | M1 | D3 | TL | $R_g$ | a* | b* | n (D1) |
|---|---|---|---|---|---|---|---|---|---|---|---|
| 17 | G |  | NiCrW 51 | $Si_3N_4$ 494 | NiCrW 597 | $Si_3N_4$ 500 | 0,35 | 6,7 | 5,9 | -0,47 |  |
| 18 | G | SiON 693 | NiCrW 41 | $Si_3N_4$ 514 | NiCrW 675 | $Si_3N_4$ 500 | 0,2 | 5 | 2,6 | -0,2 | 1,75 |

L'absence de couche D1 conduit à une réflexion accrue.

4. Incidence de l'indice de D2.

|  | G | D1 | M2 | D2 | M1 | D3 | TL | $R_g$ | a* | b* | n (D2) |
|---|---|---|---|---|---|---|---|---|---|---|---|
| 19 | G | $Si_3N_4$ 569 | NiCrW 58 | $TiO_2$ 374 | NiCrW 684 | $Si_3N_4$ 500 | 0,2 | 4,6 | 0,3 | -0,1 | 2,5 |
| 20 | G | $TiO_2$ 422 | NiCrW 99 | $TiO_2$ 405 | NiCrW 644 | $Si_3N_4$ 500 | 0,2 | 4,7 | 0,1 | -0,2 | 2,5 |
| 21 | G | $Si_3N_4$ 543 | NiCrW 82 | $SiO_2$ 801 | NiCrW 556 | $Si_3N_4$ 500 | 0,2 | 4,3 | 0 | -0,35 | 1,5 |

Le jeu de l'épaisseur et de l'indice permet d'atteindre les conditions d'interférence qui conduisent aux conditions recherchées avec des matériaux divers.

L'exemple 15 du tableau précédent, montre que dans des combinaisons particulières de matériau M2, dans ce cas du ZrN, l'absence de couche diélectrique spécifique n'est pas contraire à l'obtention de résultats satisfaisants.

Les exemples présentés montrent la grande diversité des combinaisons constituant des systèmes de couches susceptibles de constituer des bandes de masquage appropriées. Le choix d'un système dans ces conditions est fonction de considérations annexes comme la commodité de production de ces couches.

La formation des bandes de masquage ne revêt qu'une petite partie de la surface des vitrages. Les techniques de pulvérisation cathodique nécessitent de masquer les parties du vitrage qui ne doivent pas être revêtues. Des masques solides peuvent être appliqués sur les feuilles de verre pendant le dépôt des bandes opacifiantes. La préparation des vitrages en question passe de préférence par l'application de pellicules protectrices sur les zones qui ne doivent pas être revêtues, pellicules qui sont ensuite éliminées pour l'application des couches conductrices. Une technique de ce type est décrite par exemple dans la publication WO 03/080528.

**Revendications**

1. Vitrage automobile feuilleté composé de deux feuilles de verre réunies au moyen d'une feuille intercalaire thermoplastique, vitrage comportant un système couches conductrices appliqué sur une des feuilles, et comportant sur le bord de la même feuille une bande de masquage sensiblement opaque, en contact avec la feuille de verre, le système de couches conductrices recouvrant au moins en partie la bande de masquage, vitrage qui comporte encore des busbars d'alimentation électrique en contact avec le système de couches dans la partie recouvrant la bande de masquage, **caractérisé en ce que** la bande de masquage est constituée d'un ensemble de couches absorbant le rayonnement visible, ces couches étant formées par pulvérisation cathodique.

2. Vitrage selon la revendication 1 dans lequel la bande de masquage appliquée sur une feuille de verre clair de 4mm d'épaisseur est telle que la transmission lumineuse visible à travers cette bande est au plus de 1% et de préférence au plus de 0,5%, et de façon particulièrement préféré au plus de 0,1%.

3. Vitrage selon l'une des revendications précédentes dans lequel la bande de masquage présente un ensemble de couches dont l'épaisseur totale n'est pas supérieure à 4000Å, et de préférence pas supérieure à 3000Å.

4. Vitrage selon l'une des revendications précédente dans lequel la bande de masquage comprend au moins une couche métallique ou à base d'un composé métallique absorbante/réfléchissante comprenant un métal ou alliage métallique des métaux du groupe : W, Cr, Ta, Al, Cu, Nb, Zr, Ti, Nb, Mo, V, Hf et, NiCr, CoCr, ZrCr, NbCr et NiCrW, les aciers inoxydables, ainsi que les composés partiellement ou totalement nitrurés de ces métaux et alliages.

5. Vitrage selon la revendication 4 dans lequel la couche métallique absorbante/réfléchissante présente un coefficient d'absorption k (moyenne des coefficients sur le domaine des longueurs d'onde du visible, 350-750nm) qui n'est pas inférieur à 2,5 et de préférence pas inférieur à 3.

**6.** Vitrage selon la revendication 4 ou la revendication 5 dans lequel la couche métallique absorbante/réfléchissante présente une épaisseur qui n'est pas inférieure à 300Å, et de préférence pas inférieure à 400Å.

**7.** Vitrage selon la revendication 6 dans lequel la bande métallique absorbante/réfléchissante a une épaisseur qui n'est pas supérieure à 1000Å, et de préférence pas supérieure à 900Å.

**8.** Vitrage selon l'une des revendications précédentes dans lequel la bande de masquage appliquée sur une feuille de verre clair de 4mm d'épaisseur présente une réflexion côté verre qui n'est pas supérieure à 8% et de préférence pas supérieure à 5%.

**9.** Vitrage selon l'une des revendication précédentes dans lequel la bande de masquage comprend aussi une deuxième couche absorbante/réfléchissante de même nature ou de nature différente de celle de la première couche, cette deuxième couche, avec des couches diélectriques complétant le système constituant la bande de masquage, étant choisie de manière à constituer un système optique interférentiel pour neutraliser en partie au moins la réflexion globale du côté de la feuille de verre sur laquelle ce système de couches est appliqué, cette seconde couche absorbante/réfléchissante étant située entre la feuille de verre et la première couche absorbante/réfléchissante.

**10.** Vitrage selon la revendication 9 dans lequel la deuxième couche absorbante/réfléchissante est constituée d'une des métaux et alliages du groupe comprenant : W, Cr, Ta, Nb, Zr, Ti, Nb, Mo, V, Hf et, NiCr, CoCr, ZrCr, NbCr et NiCrW, les aciers inoxydables, ainsi que les composés partiellement ou totalement nitrurés de ces métaux et alliages.

**11.** Vitrage selon la revendication 9 ou la revendication 10 dans lequel l'épaisseur de la seconde couche absorbante/réfléchissante est comprise entre le tiers et le dixième de l'épaisseur de la première couche absorbante/réfléchissante.

**12.** Vitrage selon l'une des revendications 9 à 11 dans lequel la seconde couche absorbante/réfléchissante est telle que le produit de l'indice de réfraction du matériau constitutif, $\underline{n}$, par la valeur du coefficient d'extinction $\underline{k}$ (moyenne des coefficients sur le domaine des longueurs d'onde du visible, 350-750nm), et par l'épaisseur de la couche $\underline{e}$ exprimée en Angström, k.n.e est d'au moins 300 et de préférence d'au moins 400.

**13.** Vitrage selon l'une de revendications précédentes dans lequel la bande de masquage comprend des couches diélectriques essentiellement transparentes contribuant à la formation du système interférentiel.

**14.** Vitrage selon la revendication 13 dans lequel une première couche diélectrique appliquée directement sur la feuille de verre portant la bande de masquage, présente un indice de réfraction supérieur à 1,5 et de préférence supérieur à 1,7.

**15.** Vitrage selon la revendication 13 dans lequel les couches diélectriques sont des couches $Si_3N_4$, $SiO_xN_y$, AlN.

**16.** Vitrage selon l'une des revendications 9 à 15 dans lequel la bande de masquage présente la structure G/D1/M2/D2/M1/D3, dans laquelle M1 et M2 sont respectivement la première et la seconde couche absorbante/réfléchissante, et D1,D2, D3 sont des couches diélectriques, la couche D3 ayant essentiellement un rôle de protection mécanique et/ou chimique des couches sous-jacentes.

**17.** Vitrage selon l'une des revendications 4 à 16 dans lequel la première couche métallique absorbante/réfléchissante est une couche constituée d'un alliage qui comprend en poids au moins 40% de tungstène.

**18.** Vitrage selon la revendication 17 dans lequel la couche métallique absorbante comprend en outre du chrome.

**19.** Vitrage selon la revendication 17 ou la revendication 18, dans lequel la deuxième couche absorbante/réfléchissante est de même nature que celle de la première couche absorbante/réfléchissante.

**20.** Vitrage selon l'une des revendications précédentes dans lequel le système de couches conductrices chauffantes est formé par pulvérisation cathodique et comprend un ensemble de couches métalliques et de couches diélectriques, l'ensemble présentant une épaisseur qui n'est pas supérieure à 4000Å (0,4μ).

Fig.1

Fig.2

**EP 2 977 202 A1**

| | Europäisches Patentamt<br>European Patent Office<br>Office européen des brevets | **RAPPORT DE RECHERCHE EUROPEENNE** | Numéro de la demande<br>EP 14 17 8590 |

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | WO 2011/131958 A1 (PILKINGTON GROUP LTD [GB]; DIXON JONATHAN BARCLAY [GB]; CHAMBERLAIN MA)<br>27 octobre 2011 (2011-10-27)<br>* abrégé *<br>----- | 1-20 | INV.<br>B32B17/10<br>H05B3/20<br>C03C27/12 |
| A | US 5 270 517 A (FINLEY JAMES J [US])<br>14 décembre 1993 (1993-12-14)<br>* abrégé *<br>----- | 1-20 | |
| A | WO 2004/082934 A1 (PILKINGTON ITALIA SPA [IT]; GAGLIARDI GIOVANNI [IT]; DI MARIO LUIGI [I] 30 septembre 2004 (2004-09-30)<br>* abrégé *<br>----- | 1-20 | |
| A | EP 0 997 266 A1 (SIV SOC ITALIANA VETRO [IT]) 3 mai 2000 (2000-05-03)<br>* abrégé *<br>----- | 1-20 | |
| A,D | WO 2012/095380 A1 (AGC GLASS EUROPE [BE]; DUSOULIER LAURENT [BE])<br>19 juillet 2012 (2012-07-19)<br>* abrégé *<br>----- | 1-20 | **DOMAINES TECHNIQUES RECHERCHES (IPC)**<br>B32B<br>H05B |

Le présent rapport a été établi pour toutes les revendications

| Lieu de la recherche | Date d'achèvement de la recherche | Examinateur |
|---|---|---|
| Munich | 19 janvier 2015 | Ansorge, Markus |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
 
& : membre de la même famille, document correspondant

EPO FORM 1503 03.82 (P04C02)

12

**ANNEXE AU RAPPORT DE RECHERCHE EUROPEENNE
RELATIF A LA DEMANDE DE BREVET EUROPEEN NO.**

EP 14 17 8590

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

19-01-2015

| Document brevet cité au rapport de recherche | Date de publication | Membre(s) de la famille de brevet(s) | Date de publication |
|---|---|---|---|
| WO 2011131958 A1 | 27-10-2011 | CN 102947085 A | 27-02-2013 |
| | | EP 2560813 A1 | 27-02-2013 |
| | | JP 2013529168 A | 18-07-2013 |
| | | US 2013056135 A1 | 07-03-2013 |
| | | WO 2011131958 A1 | 27-10-2011 |
| US 5270517 A | 14-12-1993 | AUCUN | |
| WO 2004082934 A1 | 30-09-2004 | EP 1608504 A1 | 28-12-2005 |
| | | JP 2006523601 A | 19-10-2006 |
| | | WO 2004082934 A1 | 30-09-2004 |
| EP 0997266 A1 | 03-05-2000 | AT 235370 T | 15-04-2003 |
| | | AU 6362199 A | 22-05-2000 |
| | | BR 9914935 A | 14-08-2001 |
| | | DE 69906366 D1 | 30-04-2003 |
| | | DE 69906366 T2 | 04-12-2003 |
| | | EP 0997266 A1 | 03-05-2000 |
| | | EP 1135252 A1 | 26-09-2001 |
| | | JP 5124064 B2 | 23-01-2013 |
| | | JP 2002528374 A | 03-09-2002 |
| | | JP 2011037709 A | 24-02-2011 |
| | | PL 347540 A1 | 08-04-2002 |
| | | US 6495261 B1 | 17-12-2002 |
| | | WO 0026023 A1 | 11-05-2000 |
| WO 2012095380 A1 | 19-07-2012 | CN 103391905 A | 13-11-2013 |
| | | EP 2663537 A1 | 20-11-2013 |
| | | JP 2014503461 A | 13-02-2014 |
| | | KR 20140003527 A | 09-01-2014 |
| | | WO 2012095380 A1 | 19-07-2012 |

Pour tout renseignement concernant cette annexe : voir Journal Officiel de l'Office européen des brevets, No.12/82

**EP 2 977 202 A1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2012095380 A
- WO 2011147875 A
- WO 03080528 A